# FASCICULE DE BREVET EUROPEEN

(11) **EP 2 324 363 B1**
(45) Date de publication et mention de la délivrance du brevet: **25.07.2012**
(21) Numéro de dépôt: 09741401.5
(22) Date de dépôt: 11.09.2009
(51) Int. Cl.: G01R 15/20

(54) **CAPTEUR DE COURANT EN BOUCLE OUVERTE A'LARGE GAMME**
STROMSENSOR MIT OFFENER SCHLEIFE UND GROSSER REICHWEITE
WIDE-RANGE OPEN-LOOP CURRENT SENSOR

(30) Priorité: 12.09.2008 FR 0856150
(43) Date de publication de la demande: 25.05.2011
(73) Titulaire: Electricfil Automotive, 01708 Miribel Cedex (FR)
(72) Inventeur: ANDRIEU, Olivier, F-01700 Beynost (FR); MONAVON, Raphaël, F-69100 Villeurbanne (FR); RAKOTOARISON, Lalao-Harijaona, F-01360 Beligneux (FR)
(74) Mandataire: Thibault, Jean-Marc
(86) Numéro de dépôt international: PCT/FR2009/051710
(87) Numéro de publication internationale: WO 2010/029265

(56) Documents cités:
- EP-A1- 1 811 311
- WO-A-2004/077078
- WO-A1-2006/040719
- US-A1- 2006 043 960
- US-B1- 6 426 617

## Description

La présente invention concerne le domaine technique général des capteurs de courant, et plus particulièrement le domaine des capteurs de courant en boucle ouverte.

De manière usuelle, un tel capteur comporte un boîtier dans lequel est positionné un circuit magnétique comprenant un noyau magnétique toroïdal et un entrefer, ainsi qu'un détecteur de champ magnétique ayant une cellule de détection à effet Hall disposée dans l'entrefer. Ce type de capteur est couramment utilisé dans l'automobile, par exemple pour mesurer le courant délivré par une batterie. Dans ce type de capteur, la dilatation du noyau magnétique en fonction de la température provoque une modification de l'ouverture du circuit magnétique, et par conséquence une modification de la largeur de l'entrefer. De ce fait, la précision de la mesure de courant décroît avec la montée en température.

Le document WO 2004/077078 décrit un capteur de courant visant à remédier à ce problème. Ce capteur comporte en outre une bride réalisée en matériau amagnétique, soudée au noyau magnétique de part et d'autre de l'entrefer. Cependant, cette solution présente l'inconvénient de nécessiter la fixation d'une pièce additionnelle pour réaliser la fonction de maintien géométrique de l'entrefer. De plus, la soudure de cette pièce additionnelle provoque une démagnétisation partielle du noyau magnétique au niveau de la soudure. Cette démagnétisation peut être globalement résorbée au prix d'un traitement thermique après soudure, mais cela affecte négativement le prix de revient. Par ailleurs, cette bride gêne le montage du détecteur de champ magnétique dans la mesure où elle est positionnée au niveau de l'entrefer de mesure.

Un premier objet de l'invention vise à remédier aux inconvénients de l'état de la technique, en proposant un capteur de courant à boucle ouverte simple et peu onéreux et qui offre une mesure de courant précise sur une large plage de températures de fonctionnement.

A cette fin, l'invention propose un capteur de courant électrique comportant un boîtier de montage pour le capteur de courant, un circuit magnétique comprenant un noyau magnétique comportant au moins deux parties terminales qui présentent deux extrémités en vis-à-vis pour délimiter un entrefer de mesure et un détecteur de champ magnétique comprenant une cellule de détection disposée dans l'entrefer de mesure pour mesurer le champ magnétique induit par le courant électrique circulant dans un câble traversant le circuit magnétique. Selon cet objet de l'invention, le capteur de courant comporte au moins un système de liaison entre chaque partie terminale du noyau magnétique et le boîtier pour maintenir une largeur d'entrefer de mesure sensiblement constante de manière à assurer une liaison en rapprochement/écartement des parties terminales entres elles.

De plus, un capteur de courant selon l'invention peut présenter en outre au moins l'une des caractéristiques additionnelles suivantes :
- au moins un système de liaison entre une partie terminale du noyau magnétique et le boîtier comporte des organes de liaison mâles et des organes de liaison femelles, disposés respectivement sur la partie terminale du noyau magnétique et sur le boîtier ou inversement,
- les organes de liaison mâles et femelles présentent une forme sensiblement complémentaire,
- les organes de liaison mâles sont réalisés par au moins une saillie, un picot ou un téton, tandis que les organes de liaison femelles sont réalisés par au moins un logement, une cavité ou une réservation,
- les organes de liaison mâles présentent au moins une section sensiblement triangulaire et les organes de liaison femelles présentent au moins une section complémentaire à la section de l'organe mâle,
- le capteur comporte des moyens de positionnement entre le noyau magnétique et le boîtier pour assurer, en combinaison avec le ou les système(s) de liaison, un positionnement du circuit magnétique relativement au boîtier,
- les moyens de positionnement sont au moins réalisés par le ou les système(s) de liaison,
- le boîtier est réalisé dans un matériau possédant une dilatation thermique faible, préférentiellement du polyamide chargé fibre de verre.

Par ailleurs, le capteur de courant décrit dans le document WO 2004/077078 présente un autre inconvénient, lié à l'utilisation de la technologie en boucle ouverte. Typiquement, l'intensité maximale mesurable par ce type de capteur est de l'ordre de 100 A dans les applications automobiles, au regard de l'encombrement admissible du capteur et donc des dimensions admissibles du noyau magnétique. Au-delà de cette valeur apparaissent des phénomènes de saturation du noyau magnétique entraînant une non linéarité de mesure.

Un second objet de l'invention vise donc à remédier à ces inconvénients de l'état de la technique en proposant un capteur de courant doté d'une gamme de mesure de courant étendue.

A cette fin, l'invention propose un capteur de courant électrique comportant un boîtier de montage pour le capteur de courant, un circuit magnétique comprenant un noyau magnétique comportant au moins deux parties terminales qui présentent deux extrémités en vis-à-vis pour délimiter un entrefer de mesure et un détecteur de champ magnétique comprenant une cellule de détection disposée dans l'entrefer de mesure. Selon cet autre objet de l'invention, le circuit magnétique du capteur de courant comporte en outre au moins un entrefer secondaire réalisé par une diminution de la section transversale du noyau magnétique comprise entre 10 % et 90 % de la section transversale moyenne So du noyau magnétique de manière que l'induction magnétique mesurée par le détecteur varie d'une part linéairement selon un premier coefficient pour une première plage de courant dit faible, et d'autre part, linéairement selon un deuxième coefficient pour une deuxième plage de courant dit fort, consécutive à la première plage de courant, le deuxième coefficient étant inférieur au premier coefficient.

Bien entendu, un tel entrefer secondaire peut être réalisé sur un capteur de courant qui n'est pas conforme au premier objet de l'invention.

Avantageusement, le ou les entrefer(s) secondaire(s) permette(nt) d'augmenter significativement la gamme de mesure du capteur qui passe par exemple à 300 A avec un entrefer secondaire en plus de l'entrefer de mesure.

De plus, un capteur de courant selon le second objet de l'invention peut présenter en outre au moins l'une des caractéristiques additionnelles suivantes :
- chaque entrefer secondaire est réalisé au moyen d'une fente partielle, d'un-trou débouchant ou d'un trou borgne,
- l'entrefer de mesure et le ou les entrefer(s) secondaire(s) sont répartis de manière sensiblement régulière sur le noyau magnétique.

Diverses autres caractéristiques ressortent de la description faite ci-dessous en référence aux dessins annexés qui montrent, à titre d'exemples non limitatifs, des formes de réalisation de l'objet de l'invention.

La **Figure 1** est une vue éclatée d'un capteur de courant selon le premier objet de l'invention vu dans un sens I.

La **Figure 2** est une vue du capteur de la Fig. 1 vu dans le sens II opposé au sens I.

La **Figure 3** est une vue partielle de dessus du capteur de la **Fig. 1****.**

La **Figure 4** est une vue éclatée d'un capteur de courant selon le second objet de l'invention vu dans le sens I.

Les **Figures 5A** à **5D** représentent plusieurs variantes de circuits magnétiques d'un capteur de courant selon le second objet de l'invention.

-La **Figure 6** est un graphique donnant l'induction magnétique dans l'entrefer de mesure d'un capteur de courant dont le noyau magnétique comporte un entrefer secondaire réalisé au moyen d'une fente partielle.

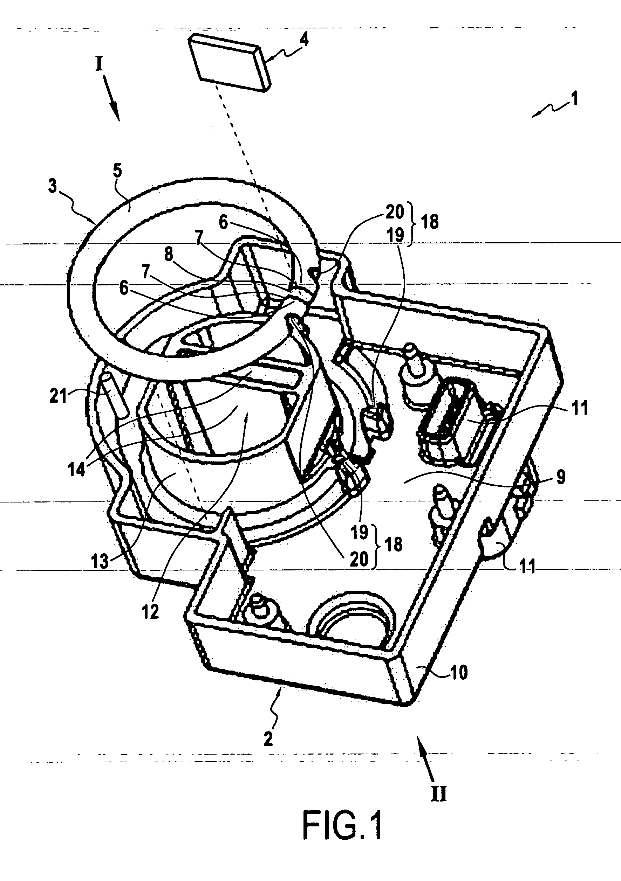

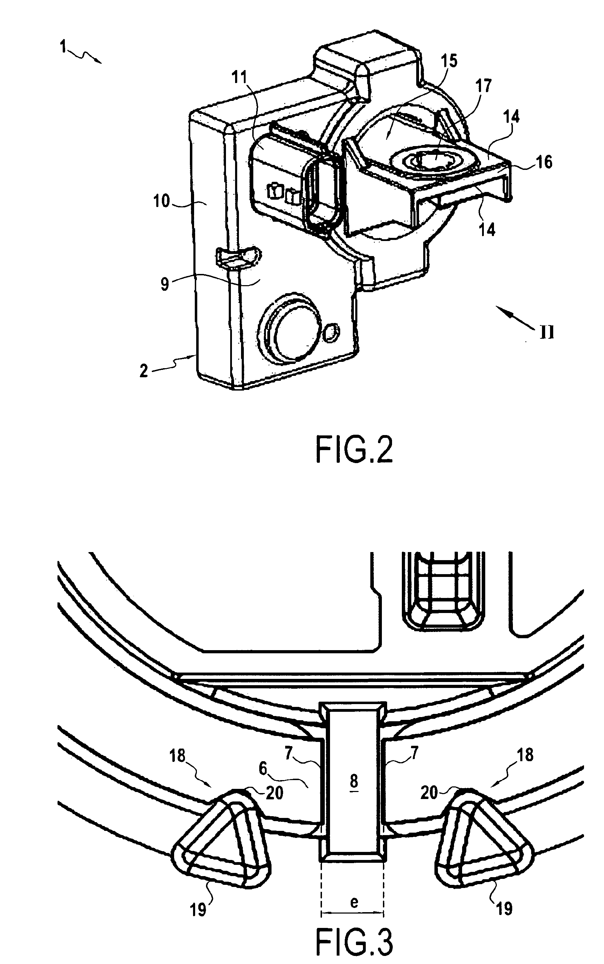

Les **Fig. 1** et **2** représentent un exemple de capteur de courant **1** selon le premier objet de l'invention. Dans cet exemple de réalisation, le capteur de courant **1** est destiné à mesurer le courant traversant un câble d'alimentation non représenté d'une batterie automobile, de manière à fournir des informations notamment à un système de gestion et de contrôle de la batterie.

Ce capteur de courant **1** comprend un boîtier **2** dans lequel est positionné un circuit magnétique **3** et un détecteur de champ magnétique **4.**

Le circuit magnétique **3** est bouclé de manière à permettre la circulation d'un champ magnétique en son sein. Il comprend un noyau magnétique **5** comportant au moins deux parties terminales **6** qui présentent deux extrémités ou faces transversales **7** en vis-à-vis pour délimiter un entrefer de mesure **8**. La largeur d'entrefer de mesure **e** (**Fig. 3**) se définit comme la distance moyenne entre les deux extrémités **7.**

Dans l'exemple de réalisation, le noyau magnétique **5** est réalisé sous la forme d'un tore ouvert à section droite circulaire et doté d'un axe de génératrice. Avantageusement, cela permet de minimiser les coûts de fabrication en permettant la réalisation du noyau magnétique **5** à partir d'un barreau mis en forme.

Bien entendu, le noyau magnétique **5** peut présenter d'autres configurations géométriques. Par exemple, le noyau magnétique **5** peut être de forme substantiellement circulaire, rectangulaire ou ovale. Dans le même sens, il peut être par exemple de section droite transversale substantiellement circulaire ou rectangulaire. Par ailleurs, le noyau magnétique **5** peut se présenter sous la forme d'une seule partie ou peut se composer d'au moins deux portions accolées ou non. Suivant les cas, le noyau magnétique **5** peut être obtenu par formage, par usinage ou par empilage de tôles.

En outre, le noyau magnétique **5** est réalisé en un matériau magnétique doux à très faible champ coercitif. Par exemple, le noyau magnétique **5** peut être réalisé en alliage FeNi car ce matériau conduit bien le flux magnétique ce qui augmente l'immunité aux perturbations du champ extérieur et ce qui réduit l'hystérésis du capteur.

Le détecteur de champ magnétique **4** comprend au moins une cellule de mesure, par exemple une cellule de mesure à effet Hall, disposée dans l'entrefer de mesure **8** et reliée à des moyens de traitement. Le détecteur **4** mesure ainsi le champ magnétique induit par le courant électrique à mesurer.

Le boîtier **2** comporte un fond **9** délimité par des parois latérales **10** qui s'élèvent sensiblement à l'équerre par rapport au fond **9**. Par convention, on considère que le côté interne est le côté du fond **9** où s'élèvent les parois latérales **10**, le côté externe étant le côté opposé.

Le boîtier **2** comporte des moyens de connexion électriques **11** situés de part et d'autre du fond **9**, lesdits moyens de connexion électrique **11** étant destinés à coopérer par assemblage avec un connecteur non représenté relié au système de gestion et de contrôle de la batterie. Une fois le connecteur assemblé aux moyens de connexion électrique **11**, il est en outre électriquement connecté aux moyens de traitement du détecteur de champ magnétique **4** par tout moyen usuel connu de l'homme du métier.

Le boîtier **2** comporte également une ouverture débouchante **12** aménagée dans le fond **9** et délimitée par une jupe **13** qui s'élève sensiblement à l'équerre du côté interne et depuis le fond **9**.

Dans cet exemple de réalisation, l'ouverture **12** est compartimentée par deux parois radiales **14** qui délimitent une console **15** s'étendant en saillie de part et d'autre de l'ouverture **12**. La console **15** s'étend du côté interne jusqu'au bord libre de la jupe et du côté externe jusqu'à un bord de console **16.** La console **15** comprend en outre un alésage débouchant **17** situé à proximité du bord de console **16**.

Le câble d'alimentation est pourvu d'une languette plate destinée à être connectée à la batterie et dotée d'un alésage sur son extrémité. Cette languette est destinée à passer au travers de l'ouverture **12**, de manière à ce que le capteur mesure le courant traversant la languette plate- et donc le câble d'alimentation. Ainsi, le détecteur **4** mesure le champ magnétique induit par le courant électrique circulant dans le câble d'alimentation traversant le circuit magnétique **3**. Au moins une paroi radiale **14** est destinée à guider en translation la languette du câble d'alimentation à travers le capteur de courant **1** et à la positionner de manière que l'alésage de la languette plate soit sensiblement en coïncidence avec l'alésage débouchant **17**. Avantageusement, la languette du câble d'alimentation et le capteur de courant **1** peuvent donc être fixés simultanément sur une platine de cosse de batterie, ce qui permet d'assurer un positionnement stable et peu sensible aux vibrations du câble d'alimentation et du capteur relativement à la batterie.

Conformément à l'invention, le capteur de courant **1** comporte au moins un système de liaison **18** entre chaque partie terminale **6** du noyau magnétique **5** et le boîtier **2**. Ce ou ces système(s) de liaison **18** a (ont) pour but d'assurer une liaison en rapprochement/écartement des parties terminales entres elles, et par ce biais de maintenir une largeur d'entrefer de mesure **e** sensiblement constante quelle que soit la dilatation thermique du noyau magnétique **5**. Avantageusement, la mesure de l'induction du noyau magnétique **5** par la cellule de mesure du détecteur de champ magnétique **4** ne dépend donc pas de la dilatation thermique du noyau magnétique **5**. Cela permet d'obtenir une mesure de courant sensiblement indépendante de la température.

Avantageusement, chaque système de liaison **18** est-réalisé sur chaque partie terminale **6** à proximité de la face transversale **7** qui le délimite. Compte tenu de la faible largeur de l'entrefer de mesure **e**, les systèmes de liaison **18** sont situés à proximité l'un de l'autre et de part et d'autre des faces transversales **7**.

Par exemple et de manière non limitative, au moins un système de liaison **18** entre chaque partie terminale **6** et le boîtier **2** peut comporter des organes de liaison mâles **19** et femelles **20**, disposés respectivement sur chaque partie terminale **6** du noyau magnétique **5** et sur le boîtier **2**, ou inversement. Lesdits organes de liaison mâles **19** peuvent être réalisés par exemple par au moins une saillie, un picot ou un téton, tandis que _lesdits organes de liaison femelles **20** peuvent être réalisés par exemple par au moins un logement, une cavité ou une réservation. Dans ce cas, les organes de liaison mâles **19** et femelles **20** ont préférentiellement une forme sensiblement complémentaire de manière à coopérer par emboîtement.

Dans l'exemple préféré de réalisation représenté **Fig. 3**, le boîtier **2** comporte deux systèmes de liaison **18**, composés chacun d'un organe de liaison mâle **19** disposé sur le boîtier **2** et d'un organe de liaison femelle **20** disposé sur le noyau magnétique **5**. Chaque organe de liaison mâle **19** est une saillie par exemple de section sensiblement triangulaire qui s'élève sensiblement à l'équerre à partir du fond **9**, tandis que chaque organe de liaison femelle **20** est une rainure qui s'étend à partir de la face externe du noyau magnétique **6** selon une direction parallèle à l'axe de génératrice du tore du noyau magnétique **5** et qui possède dans l'exemple, une section sensiblement complémentaire à la section dudit organe de liaison mâle **19**.

Dans ces conditions, la variation de la largeur de l'entrefer **e** due à la dilatation thermique est identique à la variation de distance entre les organes de liaison mâles **19** causée par la dilatation du boîtier **2**, ce qui diminue la contrainte mécanique sur le circuit magnétique **3** et limite l'effet d'hystérésis. En prenant soin de limiter la distance entre les organes de liaison mâles **19**, l'incertitude sur la mesure de courant reste compatible avec le degré de précision nécessaire à une mesure de courant sur un véhicule automobile.

Il va de soi que la liaison entre chaque partie terminale **6** et le boîtier **2** peut être réalisée par d'autres types de systèmes de liaison **18** conformes au premier objet de l'invention. Par exemple, il est possible de réaliser cette liaison par un système de liaison **18** comprenant deux organes de liaison mâle **19** jointifs et disposés sur le boîtier **2**, ainsi que deux organes de liaisons femelles **20** disjoints et disposés respectivement sur chaque partie terminale **6**. Il est également possible de réaliser cette liaison par des systèmes de liaison **18** ne comprenant pas d'organes de liaison mâles **19** et femelles **20**, par exemple des dispositifs de fixation rapportés sur le noyau magnétique **5**. Bien entendu, ces exemples n'ont pas de caractère limitatif.

Le noyau magnétique **5** est logé autour de la jupe **13** et repose en appui sur le fond **9**. Le capteur de courant **1** présente des moyens de positionnement **21** entre le noyau magnétique **5** et le boîtier **2** qui permettent avantageusement d'obtenir, en combinaison avec le ou les système(s) de liaison **18,** un positionnement stable et reproductible du circuit magnétique **3** relativement au boîtier **2**. A cette fin, les moyens de positionnement **21** empêchent, en combinaison avec le ou les système(s) de liaison **18**, les déplacements du noyau magnétique **5** relativement au boîtier **2**.

Comme représenté sur la **Fig. 1**, les moyens de positionnements **21** peuvent être réalisés au moyen d'au moins un élément sur lequel vient en appui le noyau magnétique **5** et placé sur le boîtier **2**, diamétralement opposé aux saillies **19** pour bloquer le noyau magnétique **5**. Il peut s'agir par exemple d'un godron, d'une saillie ou d'un téton.

Bien entendu, les moyens de positionnement **21** peuvent être réalisés par tous les moyens usuels connus de l'homme du métier, par exemple par contact entre la jupe **13** et le noyau magnétique **5**.

Dans un mode de réalisation, les moyens de positionnement **21** sont au moins réalisés par le ou les système(s) de liaison **18**. Dans ce cas, le ou les système(s) de liaison **18** servent avantageusement à maintenir simultanément une largeur d'entrefer de mesure **e** sensiblement constante et à obtenir un positionnement précis du circuit magnétique **3** relativement au boîtier **2**. A cette fin, la liaison entre chaque partie terminale **6** et le boîtier **2** peut, par exemple, être réalisée par des systèmes de liaison **18** composés chacun d'un picot ou d'un téton disposé sur le boîtier **2** ainsi que d'un orifice disposé sur le noyau magnétique **5** et coopérant par emboîtement avec le picot ou le téton.

Dans l'exemple de réalisation ci-dessus, le fond **9**, les parois latérales **10**, les moyens de connexion électrique **11**, la console **15** ainsi que les organes de liaison mâles **19** sont réalisés sous la forme d'une seule pièce en plastique injectée. Avantageusement, un plastique doté d'un faible coefficient de dilatation thermique, par exemple du polyamide chargé fibre de verre, est employé de manière à minimiser la dilatation thermique du boîtier **2**, la variation de distance entre les organes de liaisons mâles **19** et donc la variation de largeur de l'entrefer de mesure **e**.

De plus, au moins une partie du volume délimité par le fond **9**, les parois latérales **10** et la jupe **13** est destiné à être rempli par coulage de résine une fois le capteur assemblé, de manière à garantir l'étanchéité du capteur de courant **1** tout en assurant le maintien en position des différents composants.

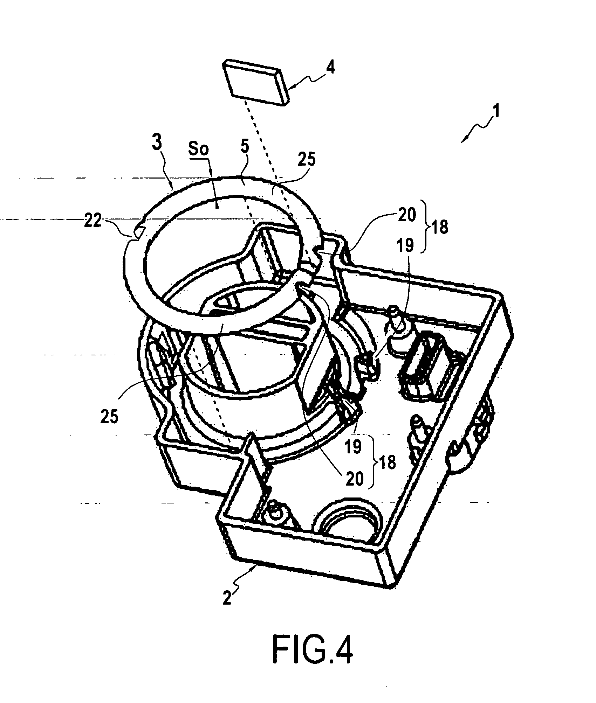

La **Fig. 4** représente un exemple de capteur de courant **1** selon le second objet de l'invention.

Dans cet exemple de réalisation et pour faciliter la compréhension générale, seules les différences entre le premier et le second objet de l'invention seront explicitées ci-après. Toute caractéristique non explicitée est donc présumée réalisée de manière similaire dans l'exemple de réalisation représenté **Fig. 1** à **3** et dans l'exemple de réalisation représenté **Fig. 4**.

Conformément à l'invention, le circuit magnétique **3** comporte en outre au moins un entrefer secondaire **22** qui retarde la saturation du capteur de courant et étend sa gamme de mesure. Chaque entrefer **22** est réalisé par une diminution de la section transversale du noyau magnétique **5** comprise entre 10 % et 90 % de la section transversale moyenne **So** du noyau magnétique **5**. En d'autres termes, le noyau magnétique **5** présente au moins un rétrécissement ou une diminution de matière qui délimite ainsi un entrefer secondaire **22**.

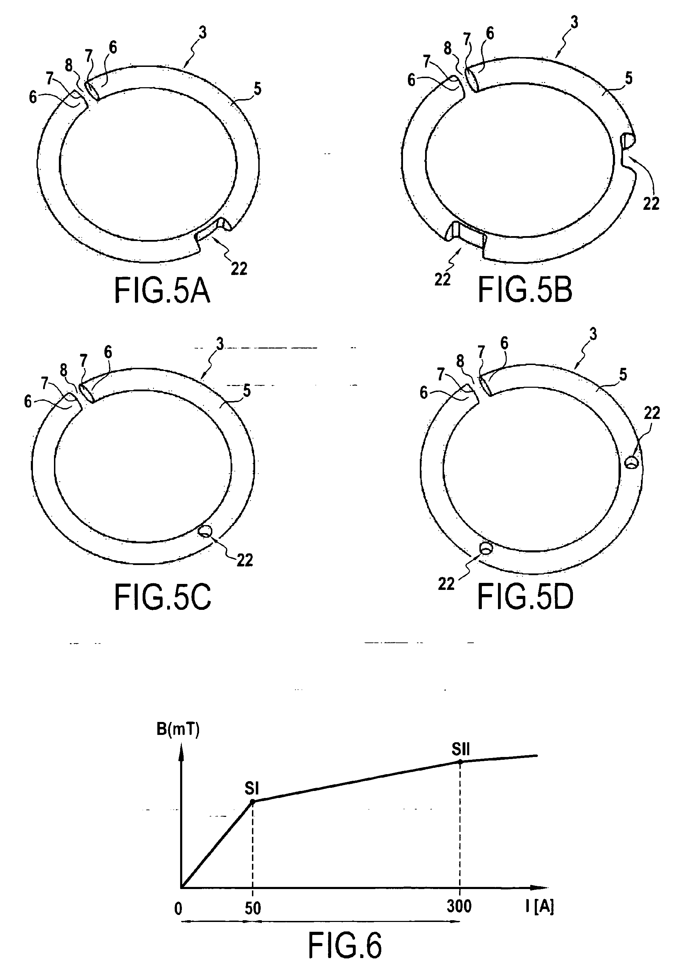

Les **Fig. 5A** à **5D** représentent plusieurs variantes de circuits magnétiques **3** d'un capteur de courant **1** selon le second objet de l'invention comportant des entrefers secondaires **22** réalisés sous différentes formes. Dans toutes ces variantes, le circuit magnétique **3** comporte un noyau magnétique **5** comprenant deux parties terminales **6** qui présentent deux extrémités en vis-à-vis **7** pour délimiter un entrefer de mesure **8**. L'entrefer secondaire **22** de la **Fig. 5A** se compose d'une fente partielle trapézoïdale, située à l'opposé de l'entrefer de mesure **8** relativement à l'axe de génératrice du tore du noyau magnétique **5**. Cette fente partielle trapézoïdale a une section sensiblement trapézoïdale dans un plan orthogonal à l'axe de génératrice du tore constituant le noyau magnétique **5.**

Dans cet exemple de réalisation, l'entrefer secondaire **22** est placé à l'opposé de l'entrefer de mesure **8** relativement à l'axe de génératrice du tore du noyau magnétique **5.**

La **Fig. 5B** diffère de la **Fig. 5A** en ce qu'elle comporte deux entrefers secondaires **22** composés chacun d'une fente partielle trapézoïdale de section sensiblement trapézoïdale dans un plan orthogonal à l'axe de génératrice du tore. L'entrefer de mesure **8** et les deux entrefers secondaires **22** sont équitablement répartis sur le pourtour du noyau magnétique **5**.

L'entrefer secondaire **22** de la **Fig. 5C** se compose d'un trou de section sensiblement circulaire dans un plan orthogonal à l'axe de génératrice du tore constituant le noyau magnétique **5**, situé à l'opposé de l'entrefer de mesure **8** relativement à l'axe de génératrice du tore du noyau magnétique **5**. Ce trou peut être débouchant ou borgne.

La **Fig. 5D** diffère de la **Fig. 5C** en ce qu'elle comporte deux entrefers secondaires **22** composés chacun d'un trou débouchant ou borgne de section sensiblement circulaire dans un plan orthogonal à l'axe de génératrice du tore. L'entrefer de mesure **8** et les deux entrefers secondaires **22** sont ici aussi équitablement répartis sur le pourtour du noyau magnétique **5**.

Il est bien évident que les fentes partielles peuvent présenter tout type de forme et que les exemples de réalisation ci-dessous n'ont qu'un caractère d'illustration.

Dans le même sens, la fente partielle peut être réalisée par la combinaison d'une fente totale et d'une pièce rapportée dans la fente totale. La pièce rapportée peut être une entretoise, par exemple une entretoise en matériau amagnétique ou magnétique, ou une partie -saillante du boîtier adaptée pour se loger dans la fente totale après le montage du capteur de courant **1**.

La **Fig. 6** est un graphique représentant l'induction magnétique **B** du circuit magnétique **5** dans l'entrefer de mesure **8,** en ordonnées, en fonction de l'intensité **I** du courant circulant dans le câble d'alimentation, en abscisses, et ce pour un capteur de courant **1** comprenant un circuit magnétique **3** réalisé selon la **Fig. 5A**.

On observe que dans les faibles intensités l'induction magnétique augmente rapidement avec le courant mesuré, ce phénomène étant dû à la fente partielle. On observe également l'absence d'offset, ce qui dénote une faible sensibilité du capteur aux champs magnétiques extérieurs. En effet, en absence d'entrefer secondaire **22**, lesdits champs magnétiques extérieurs entraînent l'apparition d'un offset dépendant de l'orientation relative du capteur **1** par rapport auxdits champs magnétiques. Ce phénomène entraîne une perte de précision sensible dans la mesure de courants faibles, par exemple inférieurs à **5A**.

La matière magnétique de l'entrefer secondaire **22** est la première zone à saturer, de par sa section plus faible que le reste du noyau magnétique **5**. Cette saturation de l'entrefer secondaire **22** dépend du rapport entre la section de la fente partielle et la section transversale moyenne **So** du noyau magnétique **5**, et correspond au point de saturation **S_{I}** du graphique. L'induction magnétique mesurée par le détecteur **4** varie linéairement selon un premier coefficient pour une première plage de courant dit faible par exemple compris entre 0 et 50 A.

Après saturation, l'entrefer secondaire **22** se comporte comme une fente totale puisque la perméabilité d'une zone saturée est assimilable à la perméabilité du vide. De ce fait, le capteur a un comportement linéaire entre le point de saturation **S_{I}** de l'entrefer secondaire **22** et le point de saturation **S_{II}** du reste du noyau magnétique **5**. L'induction magnétique mesurée par le détecteur **4** varie donc linéairement selon un deuxième coefficient et pour une seconde plage de courant prise entre les points de saturation **S_{I}**, **S_{II}** et par exemple comprise entre 50 et 300 A. Il est à noter que le deuxième coefficient de variation linéaire est inférieur au premier coefficient de variation. Il est à noter que la valeur de la section du rétrécissement qui délimite l'entrefer secondaire **22** permet de définir l'étendue de la première plage de courant.

Il est à noter que la linéarité mesurée sur une plage de courant est définie comme l'écart maximum entre les valeurs d'induction mesurées sur cette plage et celles obtenues en interpolant linéairement sur cette plage par une droite approchant au mieux l'ensemble des valeurs. Il est estimé que la plage de mesure est linéaire si cet écart est inférieur à 1 % de la valeur d'induction mesurée.

Ainsi, l'induction mesurée est globalement linéaire relativement au courant à mesurer sur l'ensemble de la gamme de mesure, avec une rupture de pente correspondant au point de saturation **S_{I}** de l'entrefer secondaire **22**. Un capteur de courant **1** doté d'un tel circuit magnétique **3** associé à un circuit électronique de traitement du signal dédié bénéficie donc simultanément d'une bonne précision dans les faibles intensités, par exemple inférieures à 50 A, et d'une plage de mesure étendue, par exemple de 0 à 300 A.

La réalisation du ou des entrefer(s) secondaire(s) **22** sous la forme de rétrécissement de section du noyau magnétique **5** permet donc de diminuer substantiellement la sensibilité aux champs magnétiques extérieurs tout en conservant le bénéfice de l'augmentation de la gamme de mesure.

L'invention n'est pas limitée aux exemples décrits et représentés car diverses modifications peuvent y être apportées sans sortir de son cadre.

## Revendications

1. - Capteur de courant électrique (**1**) comportant :
- un boîtier de montage (**2**) pour le capteur de courant (**1**),
- un circuit magnétique (**3**) comprenant un noyau magnétique (**5**) comportant au moins deux parties terminales (**6**) qui présentent deux extrémités (**7**) en vis-à-vis pour délimiter un entrefer de mesure (**8**) et
- un détecteur de champ magnétique (**4**) comprenant une cellule de détection disposée dans l'entrefer de mesure (**8**), pour mesurer le champ magnétique induit par le courant électrique circulant dans un câble traversant le circuit magnétique (**3**),
**caractérisé en ce qu'**il comporte au moins un système de liaison (**18**) entre chaque partie terminale (**6**) du noyau magnétique (**5**) et le boîtier (**2**) pour maintenir une largeur **e** d'entrefer de mesure (**8**) sensiblement constante de manière à assurer une liaison en rapprochement/écartement des parties terminales (**6**) entres elles.

2. - Capteur de courant électrique selon la revendication 1, **caractérisé en ce qu'**au moins un système de liaison (**18**) entre une partie terminale (**6**) du noyau magnétique (**5**) et le boîtier (**2**) comporte des organes de liaison mâles (**19**) et des organes de liaison femelles (**20**), disposés respectivement sur la partie terminale (**6**) du noyau magnétique (**5**) et sur le boîtier (**2**) ou inversement.

3. - Capteur de courant électrique selon la revendication 2, **caractérisé en ce que** les organes de liaison mâles (**19**) et femelles (**20**) présentent une forme sensiblement complémentaire.

4. - Capteur de courant électrique selon l'une des revendications 2 ou 3, **caractérisé en ce que** les organes de liaison mâles (**19**) sont réalisés par au moins une saillie, un picot ou un téton, tandis que les organes de liaison femelles (**20**) sont réalisés par au moins un logement, une cavité ou une réservation.

5. - Capteur de courant électrique selon l'une des revendications 2 à 4, **caractérisé en ce que** les organes de liaison mâles (**19**) présentent au moins une section sensiblement triangulaire et **en ce que** les organes de liaison femelles (**20**) présentent au moins une section complémentaire à la section de l'organe mâle.

6. - Capteur de courant selon l'une des revendications 1 à 5, **caractérisé en ce qu'**il comporte des moyens de positionnement (**21**) entre le noyau magnétique (**5**) et le boîtier (**2**) pour assurer, en combinaison avec le ou les système(s) de liaison (**18**), un positionnement du circuit magnétique (**3**) relativement au boîtier (**2**).

7. - Capteur de courant électrique selon la revendication 6, **caractérisé en ce que** les moyens de positionnement (**21**) sont au moins réalisés par le ou les système(s) de liaison (**18**).

8. - Capteur de courant selon l'une des revendications 1 à 7, **caractérisé en ce que** le boîtier (**2**) est réalisé dans un matériau plastique , préférentiellement du polyamide chargé fibre de verre.

9. - Capteur de courant selon l'une des revendications 1 à 8, **caractérisé en ce que** le circuit magnétique (**3**) comporte au moins un entrefer secondaire (**22**) réalisé par une diminution de la section transversale du noyau magnétique (**5**) comprise entre 10 % et 90% de la section transversale moyenne **So** du noyau magnétique (**5**) de manière que l'induction magnétique mesurée par le détecteur (**4**) varie d'une part linéairement selon un premier coefficient pour une première plage de courant dit faible, et d'autre part, linéairement selon un deuxième coefficient pour une deuxième plage de courant dit fort, consécutive à la première plage de courant, le deuxième coefficient étant inférieur au premier coefficient.

10. - Capteur de courant selon la revendication 9, caractérisé en ce chaque entrefer secondaire (**22**) est réalisé au moyen d'une fente partielle, d'un trou débouchant ou d'un trou borgne.

11. - Capteur de courant selon l'une des revendications 9 à 10, **caractérisé en ce que** l'entrefer de mesure (**8**) et le ou les entrefer(s) secondaire(s) (**22**) sont répartis de manière sensiblement régulière sur le noyau magnétique (**5**).

## Claims

1. - Electric current sensor (**1**) comprising:
- a casing (**2**) to mount the current sensor (**1**),
- a magnetic circuit (**3**) comprising a magnetic core (**5**) comprising at least two terminal parts (**6**) which have two facing ends (**7**) to delimit a measuring air gap (**8**) and
- a magnetic field detector (**4**) comprising a detection cell arranged in the measuring air gap (**8**), to measure the magnetic field induced by the electric current circulating in a cable passing through the magnetic circuit (**3**),
**characterized in that** it comprises at least one connection system (**18**) between each terminal part (**6**) of the magnetic core (**5**) and the casing (**2**) to maintain a substantially constant width **e** of the measuring air gap (**8**) so as to ensure a draw-near/draw-apart connection between the terminal parts (**6**).

2. - Electric current sensor according to claim 1, **characterized in that** at least one connection system (**18**) between a terminal part (**6**) of the magnetic core (**5**) and the casing (**2**) comprises male connecting members (**19**) and female le connecting members (**20**), respectively arranged on the terminal part (**6**) of the magnetic core (**5**) and on the casing (**2**), or conversely.

3. - Electric current sensor according to claim 2, **characterized in that** the male (**19**) and female (**20**) connecting members are of substantially matching shape.

4. - Electric current sensor according to either of claims 2 or 3, **characterized in that** the male connecting members (**19**) consist of at least one projection, pin or lug, whilst the female connecting members (**20**) consist of at least one housing, cavity or reservation.

5. - Electric current senor according to any of claims 2 to 4, **characterized in that** the male connecting members (**19**) have at least one substantially triangular cross-section, and **in that** the female connecting members (**20**) have at least one cross-section matching the male member cross-section.

6. - Current sensor according to any of claims 1 to 5, **characterized in that** it comprises positioning means (**21**) between the magnetic core (**5**) and the casing (**2**) so that, in combination with the connection system(s) (**18**), it can ensure positioning of the magnetic circuit (**3**) relative to the casing (**2**).

7. - Electric current sensor according to claim 6, **characterized in that** the positioning means (**21**) are at least formed by the connection system(s) (**18**).

8. - Current sensor according to any of claims 1 to 7, **characterized in that** the casing (**2**) is made in a plastic material, preferably glass-fibre reinforced polyamide.

9. - Current sensor according to any of claims 1 to 8, **characterized in that** the magnetic circuit (**3**) comprises at least one secondary air gap (**22**) obtained by a reduction in the cross-section of the magnetic core (**5**) of between 10 % and 90 % of the mean cross section **So** of the magnetic core (5) so that the magnetic induction measured by the detector (**4**) varies linearly according to a first coefficient for a first so-called low current range, and also varies linearly according to a second coefficient for a second so-called strong current range, consecutive to the first current range, the second coefficient being lower than the first coefficient.

10. - Current sensor according to claim 9, **characterized in that** each secondary air gap (**22**) consists of a partial slot, a through-hole or a blind hole.

11. - Current sensor according to any of claims 9 to 10, **characterized in that** the measuring air gap (**8**) and the secondary air gap(s) (**22**) are distributed substantially regularly over the magnetic core (**5**).

## Patentansprüche

1. Sensor für elektrischen Strom (1), umfassend:
- ein Montagegehäuse (2) für den Stromsensor (1),
- einen Magnetkreis (3), der einen Magnetkern (5) mit wenigstens zwei Endteilen (6) umfaßt, die zwei gegenüberliegende Enden (7) aufweisen, um einen Meßluftspalt (8) zu begrenzen, und
- einen Magnetfelddetektor (4), der eine Detektionszelle umfaßt, die in dem Meßluftspalt (8) angeordnet ist, um das Magnetfeld zu messen, das durch den elektrischen Strom induziert wird, der in einem den Magnetkreis (3) durchziehenden Kabel fließt,
**dadurch gekennzeichnet, daß** er wenigstens ein Verbindungssystem (18) zwischen jedem Endteil (6) des Magnetkerns (5) und dem Gehäuse (2) umfaßt, um eine im wesentlichen konstante Breite e des Meßluftspalts (8) aufrechtzuerhalten, so daß eine Verbindung beim Annähern/Entfernen der Endteile (6) untereinander sichergestellt ist.

2. Sensor für elektrischen Strom nach Anspruch 1, **dadurch gekennzeichnet, daß** wenigstens ein Verbindungssystem (18) zwischen einem Endteil (6) des Magnetkerns (5) und dem Gehäuse (2) Einsteckverbindungsorgane (19) und Aufnahmeverbindungsorgane (20) umfaßt, die an dem Endteil (6) des Magnetkerns (5) bzw. an dem Gehäuse (2) oder umgekehrt angeordnet sind.

3. Sensor für elektrischen Strom nach Anspruch 2, **dadurch gekennzeichnet, daß** die Einsteckverbindungsorgane (19) und Aufnahmeverbindungsorgane (20) eine im wesentlichen ergänzende Form aufweisen.

4. Sensor für elektrischen Strom nach einem der Ansprüche 2 oder 3, **dadurch gekennzeichnet, daß** die Einsteckverbindungsorgane (19) durch wenigstens einen Vorsprung, einen Stift oder einen Zapfen gebildet sind, während die Aufnahmeverbindungsorgane (20) durch wenigstens eine Aufnahme, einen Hohlraum oder eine Aussparung gebildet sind.

5. Sensor für elektrischen Strom nach einem der Ansprüche 2 bis 4, **dadurch gekennzeichnet, daß** die Einsteckverbindungsorgane (19) wenigstens einen im wesentlichen dreieckigen Querschnitt aufweisen und daß die Aufnahmeverbindungsorgane (20) wenigstens einen den Querschnitt des Einsteckorgans ergänzenden Querschnitt aufweisen.

6. Stromsensor nach einem der Ansprüche 1 bis 5, **dadurch gekennzeichnet, daß** er Positionierungsmittel (21) zwischen dem Magnetkern (5) und dem Gehäuse (2) umfaßt, um in Kombination mit dem oder den Verbindungssystem(en) (18) ein Positionieren des Magnetkreises (3) relativ zu dem Gehäuse (2) sicherzustellen.

7. Sensor für elektrischen Strom nach Anspruch 6, **dadurch gekennzeichnet, daß** die Positionierungsmittel (21) wenigstens durch das oder die Verbindungssystem(e) (18) ausgebildet sind.

8. Stromsensor nach einem der Ansprüche 1 bis 7, **dadurch gekennzeichnet, daß** das Gehäuse (2) aus einem Kunststoff, vorzugsweise aus mit Glasfasern versetztem Polyamid hergestellt ist.

9. Stromsensor nach einem der Ansprüche 1 bis 8, **dadurch gekennzeichnet, daß** der Magnetkreis (3) wenigstens einen Nebenluftspalt (22) aufweist, der durch eine Verringerung des Querschnitts des Magnetkerns (5) im Bereich zwischen 10 % und 90% des mittleren Querschnitts So des Magnetkerns (5) ausgebildet ist, so daß die durch den Detektor (4) gemessene magnetische Induktion einerseits entsprechend einem ersten Koeffizienten für einen ersten sogenannten Schwachstrombereich linear variiert und andererseits entsprechend einem zweiten Koeffizienten für einen zweiten sogenannten Starkstrombereich, der sich an den ersten Strombereich anschließt, linear variiert, wobei der zweite Koeffizient niedriger als der erste Koeffizient ist.

10. Stromsensor nach Anspruch 9, **dadurch gekennzeichnet, daß** jeder Nebenluftspalt (22) mittels eines Teilspalts, eines Durchgangslochs oder eines Sacklochs ausgebildet ist.

11. Stromsensor nach einem der Ansprüche 9 bis 10, **dadurch gekennzeichnet, daß** der Meßluftspalt (8) und der oder die Nebenluftspalt(e) (22) im wesentlichen gleichmäßig über den Magnetkern (5) verteilt sind.
